# EUROPEAN PATENT APPLICATION

(11) **EP 2 428 842 A1**
(43) Date of publication of application: **14.03.2012**
(21) Application number: 11181122.0
(22) Date of filing: 13.09.2011
(51) Int. Cl.: G03F 7/038, G03F 7/039

(54) **Photoresists comprising multi-amide component**

(30) Priority: 14.09.2010 US 403413 P
(71) Applicant: Rohm and Haas Electronic Materials LLC, Marlborough, MA 01752 (US)
(72) Inventor: Prokopowicz, Gregory P., Worcester, MA Massachusetts 01609 (US); Pohlers, Gerhard, Needham, MA Massachusetts 02494 (US); Liu, Cong, Shrewsbury, MA Massachusetts 01545 (US); Wu, Chunyi, Shrewsbury, MA Massachusetts 01545 (US); Xu, Cheng-Bai, Southborough, MA Massachusetts 01772 (US); Oh, Joon Seok, Natick, MA Massachusetts 01750 (US)
(74) Representative: Buckley, Guy Julian

(57) **Abstract**

New photoresist compositions are provided that comprise a component that comprises two or more amide groups. Preferred photoresists of the invention may comprise a resin with photoacid-labile groups; a photoacid generator compound; and a multi-amide component that can function to decrease undesired photogenrated-acid diffusion out of unexposed regions of a photoresist coating layer

## Description

This invention relates to photoresist compositions that comprise a component that comprises two or more amide groups. Preferred photoresists of the invention may comprise a resin with photoacid-labile groups; a photoacid generator compound; and a multi-amide component that can function to decrease undesired photogenrated-acid diffusion out of unexposed regions of a photoresist coating layer.

Photoresists are photosensitive films for transfer of images to a substrate. They form negative or positive images. After coating a photoresist on a substrate, the coating is exposed through a patterned photomask to a source of activating energy, such as ultraviolet light, to form a latent image in the photoresist coating. The photomask has areas opaque and transparent to activating radiation that define an image desired to be transferred to the underlying substrate.

Known photoresists can provide features having resolution and size sufficient for many existing commercial applications. However for many other applications, the need exists for new photoresists that can provide highly resolved images of sub-quarter-micron (< 0.25 µm) dimension.

Various attempts have been made to alter the make-up of photoresist compositions to improve performance of functional properties. Among other things, a variety of basic compounds have been reported for use in photoresist compositions. See, e.g., U.S. Patent Nos. 6,607,870 and 7,379,548, as well as Japanese published patent application JP 61-219951.

The present invention provides photoresist compositions comprising a basic acid diffusion control agent that comprises a multi-amide component. Such multi-amide component comprises more than one amide group.

The present invention further provides positive-acting photoresists comprising a multi-amide component.

Preferred multiple amide compounds may be in both positive-acting and negative-acting photoresist compositions. Photoresists of the invention suitably may comprise one or more resins (resin component) and one or more photoacid generator compounds (photoacid generator or PAG component) in addition to one or more multi-amide compounds (multi-amide component).

In a preferred aspect, photoresists of the invention are used for short-wavelength imaging applications, such as 193 nm imaging.

Particularly preferred photoresists of the invention may be used in immersion lithography applications.

As used herein, the term "alkyl" includes linear, branched and cyclic alkyl. The term "(meth)acrylate" includes both acrylate and methacrylate. Likewise, the term "(meth)acrylic" includes acrylic and methacrylic. The articles "a" and "an" refer to the singular and the plural. The following abbreviations shall have the following meanings: °C = degrees Celsius; nm = nanometers; µm = micron = micrometer; cm = centimeter; mJ = milliJoules; wt% = weight percent; and PAG = photoacid generator.

We have found that use of multi-amide compounds as disclosed herein in a photoresist composition, including chemically-amplified photoresist compositions, can significantly enhance resolution of a relief image (for example, fine lines) of the resist. In particular, we have found that an additive compound having two or more amide groups imparts significantly enhanced lithographic results, including relative to a comparable photoresist that is otherwise identical to the photoresist that instead contains an additive with a single amide group, or that contains other types of basic additives such as a multiple amine-containing compound. Use of the multi-amide compounds of the invention also can provide good shelf life to photoresists containing the compounds. The multi-amide compounds of the invention comprise two or more amide moieties. Preferably, the present multi-amide compounds have from 2 to 6 amide groups, more preferably from 2 to 4 amide groups, yet more preferably from 2 to 3 amide groups and most preferably 2 amide groups.

Without being bound by any theory, it is believed that a multi-amide compound additive can more effectively complex with photogenerated acid in an exposed region of a photoresist layer and thereby prevent undesired migration of the acid into unexposed resist layer regions, relative to the complexing provided by a comparable additive that contains a single amide moiety. That is, the present multi-amide compounds suitably function as quenchers for photogenerated acid during lithography.

Preferred multi-amide compounds of the invention for use in photoresists may be polymeric or non-polymeric, with non-polymeric multi-amide compounds preferred for many applications. Preferred multi-amide compounds have relatively low molecular weight, for example, a molecular weight of less than or equal to 3000, more preferably ≤ 2500, ≤ 2000, ≤ 1500, ≤ 1000, ≤ 800 or even more preferably ≤ 500.

A wide variety of multi-amide compounds are suitable for use in the present invention, provided they function to complex photogenerated acid under the conditions of lithography and are sufficiently soluble or dispersible in the photoresist formulation used. Such multi-amide compounds may be substituted with various groups such as hydroxyl, carboxyl (-CO₂H), carboxy(C₁-C₃₀)alkyl, (C₁-C₃₀)alkoxy, sulfonyl, sulfonic acid, sulfonate ester, cyano, halo, and keto. Preferred ester groups (carboxyalkyl) are carboxy(C₁-C₁₂)alkyl, and more preferably carboxy(C₁-C₈)alkyl. Preferred alkoxy groups are (C₁-C₁₂)alkoxy, and more preferably (C₁-C₈)alkoxy. By "substituted," it is meant that one or more hydrogens on an alkyl group or amido-alkyl group of the multi-amide compound is replaced with one or more of the above substituent groups. A mixture of such substituent groups may be used. The presence of such substituent groups may impart desired solubility to the multi-amide compound, or may be used to tailor the quenching ability of the multi-amide compound.

Particularly preferred multi-amide compounds of the invention for use in photoresists have the formula: 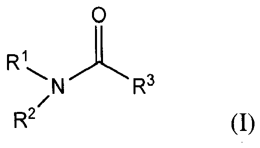 wherein R¹, R², and R³ are independently chosen from H, (C₁-C₁₃₀₂)alkyl, and amido-substituted(C₁-C₃₀)alkyl; R¹ and R², or R¹ and R³ may be taken together along with the atoms to which they are attached to form a 5- to 12-membered heterocyclic ring; and wherein at least one of R¹, R², and R³ is amido-substituted(C₁-C₃₀)alkyl. Preferably, R¹, R², and R³ are independently chosen from H, (C₁-C₁₀)alkyl, and amido-substituted(C₁-C₁₀)alkyl; more preferably from R¹, R², and R³ are independently chosen from H, (C₁-C₈)alkyl, and amido-substituted(C₁-C₈)alkyl; and still more preferably from R¹, R², and R³ are independently chosen from H, (C₁-C₆)alkyl, and amido-substituted(C₁-C₆)alkyl. Optionally, the (C₁-C₃₀)alkyl and amido-substituted(C₁-C₃₀)alkyl groups may be substituted with one or more groups chosen from hydroxyl, carboxyl, carboxy(C₁-C₃₀)alkyl, (C₁-C₃₀)alkoxy, sulfonyl, sulfonic acid, sulfonate ester, cyano, halo, and keto. Preferred substituent groups are hydroxyl, carboxyl carboxy(C₁-C₁₀)alkyl, (C₁-C₁₀)alkoxy, sulfonyl, sulfonic acid, sulfonate ester, cyano, halo, and keto; and more preferably hydroxyl, carboxyl, carboxy(C₁-C₈)alkyl, (C₁-C₈)alkoxy, sulfonyl, sulfonic acid, sulfonate ester, cyano, halo, and keto. When R¹ and R², or R¹ and R³ are taken together along with the atoms to which they are attached to form a heterocyclic ring, they may form a single heterocyclic ring, or multiple rings which may be used or spirocyclic. It is preferred that when R¹ and R², or R¹ and R³ are taken together along with the atoms to which they are attached that a 5- to 10-membered ring is formed, and more preferably a 5- to 8-membered ring, and even more preferably a 5 to 6-membered ring. It will be appreciated by those skilled in the art that a lactam is formed when R¹ and R³ are taken together along with the atoms to which they are attached to form a ring. It is preferred that R¹ and R³ are not taken together along with the atoms to which they are attached to form a ring. It is further preferred that R¹ and R² are not taken together along with the atoms to which they are attached to form a ring.

The amido-substituted(C₁-C₃₀)alkyl groups of formula (I) may contain one or more amide groups. Suitable amide groups may have either of the following formulae (II) or (III): 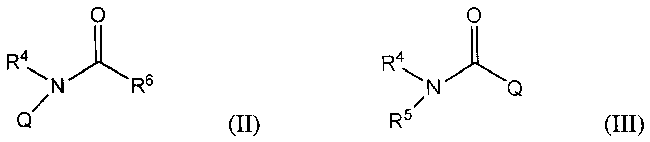 wherein R⁴, R⁵ and R⁶ are independently chosen from H, (C₁-C₃₀)alkyl, and amido-substituted(C₁-C₃₀)alkyl; and wherein Q is a (C₁-C₃₀)alkyl residue. Preferably, R⁴, R⁵ and R⁶ are independently chosen from H, (C₁-C₁₀)alkyl, and amido-substituted(C₁-C₁₀)alkyl, more preferably from H, (C₁-C₈)alkyl, and amido-substituted(C₁-C₈)alkyl, and still more preferably from H and (C₁-C₆)alkyl. It is preferred that the amido-substituted(C₁-C₃₀)alkyl groups of formula (I) contain 1 to 3 amide groups, more preferably from 1 to 2 amido groups, and most preferably 1 amido group. It is preferred that the amido-substituted(C₁-C₁₂₃₀)alkyl groups of formula (I) are amido-substituted(C₁-C₁₀)alkyl groups; more preferably amido-substituted(C₂-C₈)alkyl groups; and even more preferably amido-substituted(C₂-C₆)alkyl groups.

It is preferred that the multi-amide compound additives exclude nitrogen ring compounds where a ring carbon atom adjacent to a ring nitrogen from a keto group to thereby provide ring-amide group (i.e. ring nitrogen and carbon atoms of -N-C(=O)-. It is further preferred that the multi-amide compound additive excludes nitrogen ring compounds, particularly where both amide groups are ring members, rather than one or both of the amide groups are ring substituents (i.e. substituted to a ring atom). More preferably, excluded from use as a multi-amide compound additives are piperazine compounds. In still further other aspects, excluded from use as a multi-amide compound additive is sarcosine anhydride (1,4-dimethylpiperazine-2,5-dione).

Preferred multi-amide compounds exhibit good solubility in organic photoresist solvents such as ethyl lactate, propylene glycol methyl ether acetate (PGMEA), cyclohexanone and mixtures thereof. In one aspect, preferred are multi-amide compounds that comprise hydroxyl groups "blocked" (i.e. covalently linked to) photoacid-labile groups such as t-butyl esters that can cleave and provide a hydroxyl group in the presence of photogenerated-acid in a photoresist composition coating layer.

Preferred multi-amide compounds for use in photoresists of the invention may have amide groups in a trans configuration on a cycloalkyl ring, for example, where the amide groups are substituents of a cyclohexyl ring and are arranged in a trans configuration. Alternatively, preferred multi-amide compounds for use in photoresists of the invention may have amide groups in a cis configuration on a cycloalkyl ring, for example, where the amide groups are substituents of a cyclohexyl ring and are arranged in a cis configuration.

Exemplary multi-amide compounds useful in the present invention include, without limitation, one or more of the following: *cis*-N,N'-(cyclohexane-1,2-diyl)diacetamide; *trans-*N,N'-(cyclohexane-1,2-diyl)diacetamide; *cis*-N,N'-(cyclohexane-1,3-diyl)diacetamide; *trans-*N,N'-(cyclohexane-1,3-diyl)diacetamide; *cis*-N,N'-(cyclohexane-1,4-diyl)diacetamide; *trans-*N,N'-(cyclohexane-1,4-diyl)diacetamide; *cis*-N,N'-(cyclohexane-1,2-diyl)bis(N-methylacetamide); *trans*-N,N'-(cyclohexane-1,2-diyl)bis(N-methylacetamide); N,N'-diacetylethylenediamine; N,N,N',N'-tetramethyltartardiamide; piperazine-1,4-dicarbaldehyde; N,N,N',N'-tetramethylmalonamide; N,N,N',N',-tetrabutylmalonamide; N,N,N',N'-tetrakis(2-hydroxyethyl)adipamide; and (adipoylbis(azanetriyl))tetrakis(ethane-2,1-diyl) tetra-tert-butyl tetracarbonate.

Multi-amide compounds useful in the present invention are generally commercially available or can be readily synthesized. For instance, an alkylamide compound can be reacted to provide a second amide group.

Preferably, multi-amide compounds of the invention are used in positive-acting or negative-acting chemically amplified photoresists, i.e. negative-acting resist compositions which undergo a photoacid-promoted crosslinking reaction to render exposed regions of a coating layer of the resist less developer soluble than unexposed regions, and positive-acting resist compositions which undergo a photoacid-promoted deprotection reaction of acid labile groups of one or more composition components to render exposed regions of a coating layer of the resist more soluble in an aqueous developer than unexposed regions. Ester groups that contain a tertiary non-cyclic alkyl carbon or a tertiary alicyclic carbon covalently linked to the carboxyl oxygen of the ester are generally preferred photoacid-labile groups of resins employed in photoresists of the invention. Acetal groups also are suitable photoacid-labile groups.

Photoresists of the invention typically comprise a resin binder (polymer), a photoactive component such as a photoacid generator, and a multi-amide compound as described above. Preferably the resin binder has functional groups that impart alkaline aqueous developability to the photoresist composition. For example, preferred are resin binders that comprise polar functional groups such as hydroxyl or carboxylate. Preferably the resin binder is used in a resist composition in an amount sufficient to render the resist developable with an aqueous alkaline solution.

Preferred imaging wavelengths of the photoresists of the invention include sub-300 nm wavelengths, such as 248 nm, and more preferably sub-200 nm wavelengths, such as 193 nm and EUV.

Particularly preferred photoresists of the invention may be used in immersion lithography applications. See, for example, U.S. 2006/0246373 to Rohm and Haas Electronic Materials for a discussion of preferred immersion lithography photoresists and methods. Preferred photoresists for use in immersion application may comprise a resin (which may be fluorinated and/or have photoacid-labile groups) that is separate (not covalently linked) and distinct from a primary resin that has photoacid-labile groups. Thus, the present invention includes in preferred aspects photoresists that comprise: 1) a first resin with photoacid-labile groups; 2) one or more photoacid generator compounds; 3) a second resin that is separate and distinct from the first resin, the second resin may be fluorinated and/or have photoacid-acid groups; and 4) one or more multi-amide compounds.

Particularly preferred photoresists of the invention contain an imaging-effective amount of one or more PAGs and one or more multi-amide compounds as disclosed herein and a resin that is selected from the group of:
1) a phenolic resin that contains acid-labile groups that can provide a chemically amplified positive resist particularly suitable for imaging at 248 nm. Particularly preferred resins of this class include: i) polymers that contain polymerized units of a vinyl phenol and an alkyl (meth)acrylate, where the polymerized alkyl (meth)acrylate units can undergo a deblocking reaction in the presence of photoacid. Exemplary alkyl (meth)acrylates that can undergo a photoacid-induced deblocking reaction include e.g. t-butyl acrylate, t-butyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042,997 and 5,492,793, incorporated herein by reference; ii) polymers that contain polymerized units of a vinyl phenol, an optionally substituted vinyl phenyl (e.g. styrene) that does not contain a hydroxy or carboxy ring substituent, and an alkyl (meth)acrylate such as those deblocking groups described with polymers i) above, such as polymers described in U.S. Patent 6,042,997, incorporated herein by reference; and iii) polymers that contain repeat units that comprise an acetal or ketal moiety that will react with photoacid, and optionally aromatic repeat units such as phenyl or phenolic groups;.
2) a resin that is substantially or completely free of phenyl groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbornene, such as polymers described in U.S. Patent U.S. Patent 5,843,624; ii) polymers that contain alkyl (meth)acrylate units such as e.g. t-butyl acrylate, t-butyl methacrylate, methyladamantyl acrylate, methyl adamantyl methacrylate, and other non-cyclic alkyl and alicyclic (meth)acrylates; such polymers have been described in U.S. Patent 6,057,083. Polymers of this type may contain in preferred aspects certain aromatic groups such as hydroxynaphthyl.

Preferred resins for use in photoresists to be imaged at sub-200 nm, such as at 193 nm, comprises units of the following general formulae (I), (II) and (III): 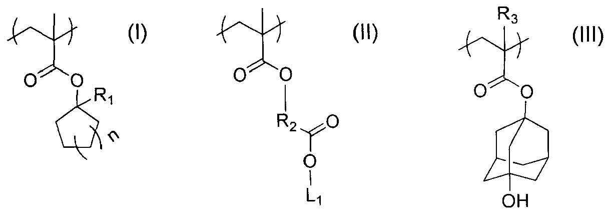 wherein: R₁ is a (C₁-C₃)alkyl group; R₂ is a (C₁-C₃₎alkylene group; L₁ is a lactone group; and n is 1 or 2.

The unit of general formula (I) includes an acid labile group that undergoes a photoacid-promoted deprotection reaction on exposure to activating radiation and heat treatment. This allows for a switch in polarity of the matrix polymer, leading to a change in solubility of the polymer and photoresist composition in an organic developer. Suitable monomers for forming units of formula (I) include, for example, the following:

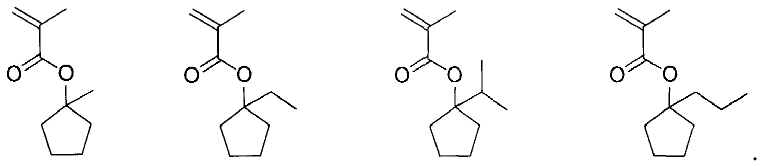

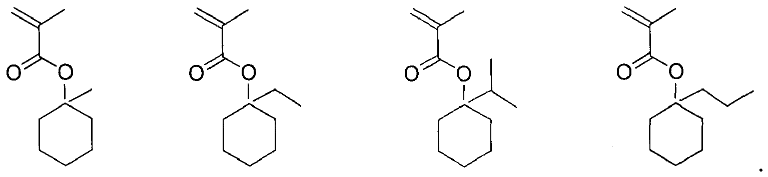

The unit of general formula (II) includes a lactone moiety effective to control the dissolution rate of the matrix polymer and photoresist composition. Suitable monomers for forming units of general formula (II) include, for example, the following:

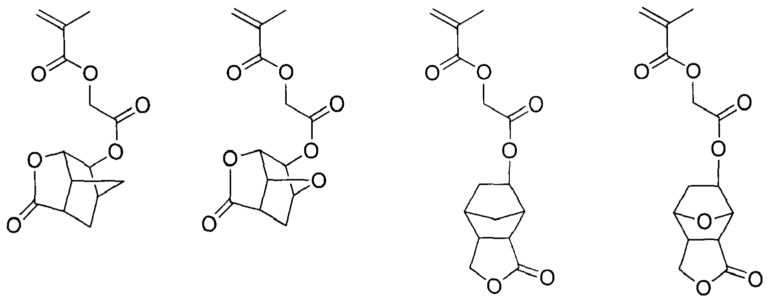

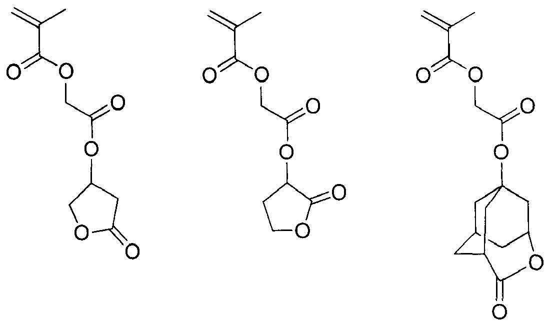

The unit of formula (III) provides a polar group, which enhances etch resistance of the resin and photoresist composition and provides additional means to control the dissolution rate of the resin and photoresist composition. Monomers for forming the unit of formula (III) include 3-hydroxy-1-adamantyl methacrylate (HAMA) and preferably 3-hydroxy-1-adamantyl acrylate (HADA).

The resin can include one or more additional units of general formulae (I), (II) and/or (III) different from the first units. Where additional such units are present in the resin, they will preferably include an additional leaving group-containing unit of formula (I) and/or a lactone-containing unit of formula (II).

In addition to the polymerized units described above, the resin can include one or more additional units which are not of general formula (I), (II) or (III). For example, a particularly suitable lactone group-containing unit is of the following general formula (IV): 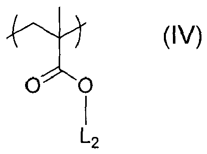 wherein: L₂ is a lactone group; and the unit of general formula (IV) is different from the unit of general formula (II). The following exemplary monomers are suitable for use in forming the additional lactone unit of general formula (IV):

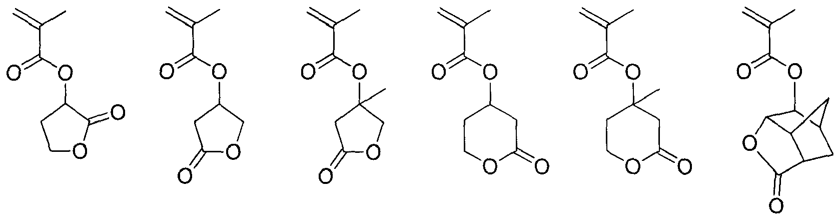

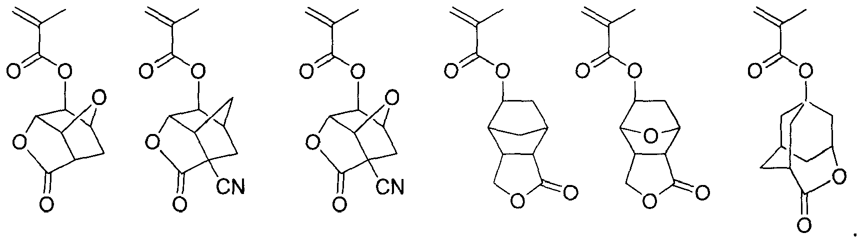

Preferably, L₁ in the unit of general formula (II) and L₂ in the unit of general formula (IV) are independently chosen from the following lactone groups:

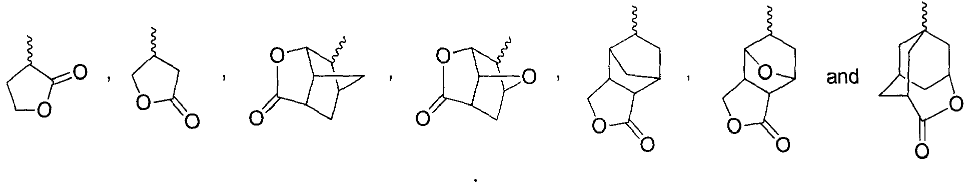

Typically, the additional units for the resin will include the same or similar polymerizable group as those used for the monomers used to form the units of general formula (I), (II) or (III), but may include other, different polymerizable groups in the same polymer backbone, such as those which contain polymerized units of vinyl or a non-aromatic cyclic olefin (endocyclic double bond) such as an optionally substituted norbornene. For imaging at sub-200 nm wavelengths such as 193 nm, the resin is typically substantially free (that is, less than 15 mole%) of phenyl, benzyl or other aromatic groups where such groups are highly absorbing of the radiation. Suitable additional monomeric units for the polymer include, for example, one or more of the following: monomeric units containing ethers, lactones or esters, such as 2-methyl-acrylic acid tetrahydro-furan-3-yl ester, 2-methyl-acrylic acid 2-oxo-tetrahydro-furan-3-yl ester, 2-methyl-acrylic acid 5-oxo-tetrahydro-furan-3-yl ester, 2-methyl-acrylic acid 3-oxo-4,10-dioxa-tricyclo [5.2.1.02,6] dec-8-yl ester, 2-methyl-acrylic acid 3-oxo-4-oxa-tricyclo [5.2.1.02,6] dec-8-yl ester, 2-methyl-acrylic acid 5-oxo-4-oxa-tricyclo [4.2.1.03,7] non-2-yloxycarbonylmethyl ester, acrylic acid 3-oxo-4-oxa-tricyclo [5.2.1.02,6] dec-8-yl ester, 2-methyl-acrylic acid 5-oxo-4-oxa-tricyclo [4.2.1.03,7] non-2-yl ester, and 2-methyl-acrylic acid tetrahydro-furan-3-yl ester; monomeric units having polar groups such as alcohols and fluorinated alcohols, such as 2-methyl-acrylic acid 3-hydroxy-adamantan-1-yl ester, 2-methyl-acrylic acid 2-hydroxyethyl ester, 6-vinyl-naphthalen-2-ol, 2-methyl-acrylic acid 3,5-dihydroxy-adamantan-1-yl ester, 2-methyl-acrylic acid 6-(3,3,3-trifluoro-2-hydroxy-2-trifluoromethyl-propyl)-bicyclo [2.2.1] hept-2-yl, and 2-bicyclo [2.2.1] hept-5-en-2-ylmethyl-1,1,1,3,3,3-hexafluoro-propan-2-ol; monomeric units having acid labile moieties, for example, ester groups that contain a tertiary non-cyclic alkyl carbon such as t-butyl, or a tertiary alicyclic carbon such as methyladamantyl or ethylfenchyl covalently linked to a carboxyl oxygen of an ester of the polymer, 2-methyl-acrylic acid 2-(1-ethoxy-ethoxy)-ethyl ester, 2-methyl-acrylic acid 2-ethoxymethoxy-ethyl ester, 2-methyl-acrylic acid 2-methoxymethoxy-ethyl ester, 2-(1-ethoxy-ethoxy)-6-vinyl-naphthalene, 2-ethoxymethoxy-6-vinyl-naphthalene, and 2-methoxymethoxy-6-vinyl-naphthalene. The additional units if used are typically present in the polymer in an amount of from 10 to 30 mol % .

Exemplary preferred resins include, for example, the following: 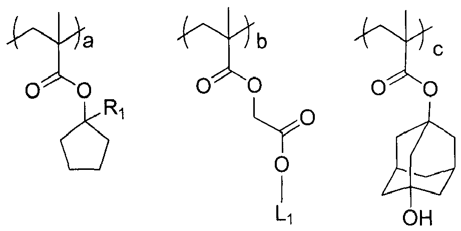 wherein: 0.3 < a < 0.7; 0.3 < b < 0.6; and 0.1 < c < 0.3; 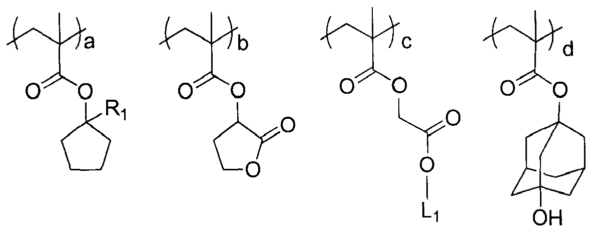 wherein: 0.3 < a < 0.7; 0.1 < b < 0.4; 0.1 < c < 0.4, and 0.1 < d <0.3; 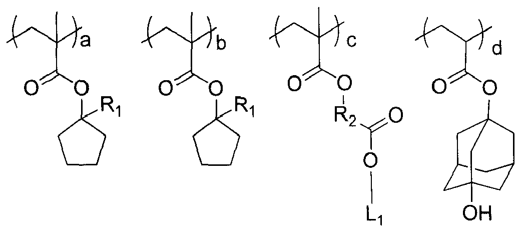 wherein: 0.1 < a < 0.5; 0.1 < b < 0.5; 0.2 < c < 0.6; and 0.1 < d < 0.3; and

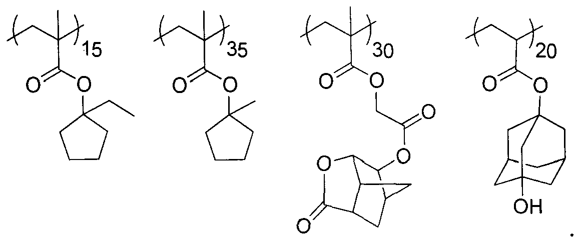

Blends of two or more resins can be used in the compositions of the invention. The resin is present in the resist composition in an amount sufficient to obtain a uniform coating of desired thickness. Typically, the resin is present in the composition in an amount of from 70 to 95 wt% based on total solids of the photoresist composition. Because of improved dissolution properties of the resin in organic developers, useful molecular weights for the resin are not limited to lower values, but cover a very broad range. For example, the weight average molecular weight M_{w} of the polymers is typically less than 100,000, for example, from 5000 to 50,000, more typically from 6000 to 30,000 or from 7,000 to 25,000.

Suitable monomers used in forming the resins are commercially available and/or can be synthesized using known methods. The resins can readily be synthesized by persons skilled in the art using the monomers with known methods and other commercially available starting materials.

Photoresists of the invention also may comprise a single PAG or a mixture of distinct PAGs, typically a mixture of 2 or 3 different PAGs, more typically a mixture that consists of a total of 2 distinct PAGs. The photoresist composition comprises a photoacid generator ("PAG") employed in an amount sufficient to generate a latent image in a coating layer of the composition upon exposure to activating radiation. For example, the photoacid generator will suitably be present in an amount of from about 1 to 20 wt% based on total solids of the photoresist composition. Typically, lesser amounts of the PAG will be suitable for chemically amplified resists as compared with non-chemically amplified materials.

Suitable PAGs are known in the art of chemically amplified photoresists and include, for example, but are not limited to: onium salts, for example, triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate; nitrobenzyl derivatives, for example, 2-nitrobenzyl-p-toluenesulfonate, 2,6-dinitrobenzyl-p-toluenesulfonate, and 2,4-dinitrobenzyl-p-toluenesulfonate; sulfonic acid esters, for example, 1,2,3-tris(methanesulfonyloxy)benzene, 1,2,3-tris(trifluoromethanesulfonyloxy)benzene, and 1,2,3-tris(p-toluenesulfonyloxy)benzene; diazomethane derivatives, for example, bis(benzenesulfonyl)diazomethane, bis(p-toluenesulfonyl)diazomethane; glyoxime derivatives, for example, bis-O-(p-toluenesulfonyl)-α-dimethylglyoxime, and bis-O-(n-butanesulfonyl)-α-dimethylglyoxime; sulfonic acid ester derivatives of an N-hydroxyimide compound, for example, N-hydroxysuccinimide methanesulfonic acid ester, N-hydroxysuccinimide trifluoromethanesulfonic acid ester; and halogen-containing triazine compounds, for example, 2-(4-methoxyphenyl)-4,6-bis(trichloromethyl)-1,3,5-triazine, and 2-(4-methoxynaphthyl)-4,6-bis(trichloromethyl)-1,3,5-triazine.

Photoresists of the invention comprise one or more multi-amide compounds in a wide amount range, such as from 0.005 to 15 wt%, based on the weight of the PAG, preferably from 0.01 to 15 wt%, and even more preferably from 0.01 to 10 wt%. The added multi-amide component is suitably used in amounts of 0.01, 0.05, 0.1, 0.02, 0.3, 0.4, 0.5 or 1 to 10 or 15 wt% relative to the PAG, and more typically amounts of 0.01, 0.05, 0.1, 0.02, 0.3, 0.4, 0.5 or 1 to 5, 6, 7, 8, 9 or 10 weight percent.

The present photoresist compositions typically comprise a solvent. Suitable solvents include, for example: glycol ethers such as 2-methoxyethyl ether (diglyme), ethylene glycol monomethyl ether, and propylene glycol monomethyl ether; propylene glycol monomethyl ether acetate; lactates such as methyl lactate and ethyl lactate; propionates such as methyl propionate, ethyl propionate, ethyl ethoxy propionate and methyl-2-hydroxy isobutyrate; Cellosolve esters such as methyl Cellosolve acetate; aromatic hydrocarbons such as toluene and xylene; and ketones such as acetone, methylethyl ketone, cyclohexanone and 2-heptanone. A blend of solvents such as a blend of two, three or more of the solvents described above also are suitable. The solvent is typically present in the composition in an amount of from 90 to 99 wt % , more typically from 95 to 98 wt % , based on the total weight of the photoresist composition.

The photoresist compositions can also include other optional materials. For example, the compositions can include one or more of actinic and contrast dyes, anti-striation agents, plasticizers, speed enhancers, sensitizers, and the like. Such optional additives if used are typically present in the composition in minor amounts such as from 0.1 to 10 wt% based on total solids of the photoresist composition.

The photoresists of the invention are generally prepared following known procedures. For example, a photoresist composition of the invention can be prepared by dissolving the components of the photoresist in a suitable solvent. The resin binder component of photoresists of the invention are typically used in an amount sufficient to render an exposed coating layer of the resist developable such as with an aqueous alkaline solution. More particularly, a resin binder will suitably comprise 50 to 90 weight percent of total solids of the resist. The photoactive component should be present in an amount sufficient to enable generation of a latent image in a coating layer of the resist. More specifically, the photoactive component will suitably be present in an amount of from 1 to 40 weight percent of total solids of a photoresist. Typically, lesser amounts of the photoactive component will be suitable for chemically amplified resists.

The desired total solids content of the present photoresist compositions will depend on factors such as the particular polymers in the composition, final layer thickness and exposure wavelength. Typically the solids content of the photoresist varies from 1 to 10 wt%, more typically from 2 to 5 wt%, based on the total weight of the photoresist composition.

Preferred negative-acting compositions of the invention comprise a mixture of materials that will cure, crosslink or harden upon exposure to acid, and a photoactive component of the invention. Particularly preferred negative acting compositions comprise a resin binder such as a phenolic resin, a crosslinker component and a photoactive component of the invention. Such compositions and the use thereof has been disclosed in European Patent Applications 0164248 and 0232972 and in U.S. Patent No. 5,128,232 to Thackeray et al. Preferred phenolic resins for use as the resin binder component include novolaks and poly(vinylphenol)s such as those discussed above. Preferred crosslinkers include amine-based materials, including melamine, glycolurils, benzoguanamine-based materials and urea-based materials. Melamine-formaldehyde resins are generally most preferred. Such crosslinkers are commercially available, e.g. the melamine resins sold by American Cyanamid under the trade names Cymel 300, 301 and 303. Glycoluril resins are sold by American Cyanamid under trade names Cymel 1170, 1171, 1172, urea-based resins are sold under the trade names of Beetle 60, 65 and 80, and benzoguanamine resins are sold under the trade names Cymel 1123 and 1125.

The photoresists of the invention can be used in accordance with known procedures. Though the photoresists of the invention may be applied as a dry film, they are preferably applied on a substrate as a liquid coating composition, dried by heating to remove solvent preferably until the coating layer is tack free, exposed through a photomask to activating radiation, optionally post-exposure baked to create or enhance solubility differences between exposed and nonexposed regions of the resist coating layer, and then developed preferably with an aqueous alkaline developer to form a relief image. The substrate on which a resist of the invention is applied and processed suitably can be any substrate used in processes involving photoresists such as a microelectronic wafer. For example, the substrate can be a silicon, silicon dioxide or aluminum-aluminum oxide microelectronic wafer. Gallium arsenide, ceramic, quartz or copper substrates may also be employed. Substrates used for liquid crystal display and other flat panel display applications are also suitably employed, for example, glass substrates, indium tin oxide coated substrates and the like. A liquid coating resist composition may be applied by any standard means such as spinning, dipping or roller coating.

The exposure energy should be sufficient to effectively activate the photoactive component of the radiation sensitive system to produce a patterned image in the resist coating layer. Suitable exposure energies typically range from about 1 to 300 mJ/cm². As discussed above, preferred exposure wavelengths include sub-200 nm such as 193 nm.

The photoresist layer (with overcoated barrier composition layer, if present) may be preferably exposed in an immersion lithography system, i.e. where the space between the exposure tool (particularly the projection lens) and the photoresist coated substrate is occupied by an immersion fluid, such as water or water mixed with one or more additives such as cesium sulfate which can provide a fluid of enhanced refractive index. Preferably the immersion fluid (for example, water) has been treated to avoid bubbles, for example water can be degassed to avoid nanobubbles.

References herein to "immersion exposing" or other similar term indicates that exposure is conducted with such a fluid layer (for example, water or water with additives) interposed between an exposure tool and the coated photoresist composition layer.

After exposure, a thermal treatment is typically employed for chemically-amplified photoresists. Suitable post-exposure bake temperatures are from 50 °C or greater, more specifically from 50 to 140 °C. For an acid-hardening negative-acting resist, a post-development bake may be employed if desired at temperatures of from 100 to 150 °C for several minutes or longer to further cure the relief image formed upon development. After development and any post-development cure, the substrate surface bared by development may then be selectively processed, for example chemically etching or plating substrate areas bared of photoresist in accordance with procedures known in the art. Suitable etchants include a hydrofluoric acid etching solution and a plasma gas etch such as an oxygen plasma etch.

The invention also provide methods for forming relief images of the photoresists of the invention, including methods for forming highly resolved patterned photoresist images (for example, a patterned line having essentially vertical sidewalls) of sub-quarter µm dimensions or less, such as sub-0.2 or sub-0.1 µm dimensions.

The invention further provides articles of manufacture comprising substrates such as a microelectronic wafer or a flat panel display substrate having coated thereon the photoresists and relief images of the invention.

### Example 1: Photoresist preparation and lithographic processing

A photoresist of the invention is prepared by mixing the following components with amounts expressed as weight percent based on total weight of the resist compositions:

| Resist components | Amount (wt%) |
|---|---|
| Resin binder | 15 |
| Photoacid generator | 4 |
| Multi-amide compound | 0.5 |
| Solvent | 81 |

The resin binder is a terpolymer (2-methyl-2-adamantyl methacrylate/beta-hydroxy-gamma-butyrolactone methacrylate/cyano-norbornyl methacrylate). The photoacid generator is the compound t-butyl phenyl tetramethylene sulfonium perfluorobutanesulfonate. The multiple amide compound is diacetylethylenediamine. The solvent component is propylene glycol methyl ether acetate admixed with cyclohexanone and ethyl lactate. The resin, PAG and multi-amide compound components are admixed in the solvent component.

The formulated resist composition is spin coated onto HMDS vapor primed 4 inch silicon wafers and softbaked via a vacuum hotplate at 90 °C for 60 seconds. The resist coating layer is exposed through a photomask at 193 nm, and then the exposed coating layers are post-exposure baked at 110 °C. The coated wafers are then treated with 0.26N (normal) aqueous tetramethylammonium hydroxide solution to develop the imaged resist layer.

### Example 2: Photoresist preparation and lithographic processing

A photoresist of the invention is prepared by mixing the following components with amounts expressed as weight percent based on total weight of the resist compositions:

| Resist components | Amount (wt.%) |
|---|---|
| Resin binder | 15 |
| Photoacid generator | 4 |
| Multi-amide compound | 0.5 |
| Solvent | 81 |

The resin binder is a terpolymer (2-methyl-2-adamantyl methacrylate/beta-hydroxy-gamma-butyrolactone methacrylate/cyano-norbornyl methacrylate). The photoacid generator is the compound t-butyl phenyl tetramethylene sulfonium perfluorobutanesulfonate. The multiple amide compound is trans-diacetylcyclohexanediamine. The solvent component is propylene glycol methyl ether acetate admixed with cyclohexanone and ethyl lactate. The resin, PAG and multiple amide compound components are admixed in the solvent component.

The formulated resist composition is spin coated onto HMDS vapor primed 4 inch silicon wafers and softbaked via a vacuum hotplate at 90 °C for 60 seconds. The resist coating layer is exposed through a photomask at 193 nm, and then the exposed coating layers are post-exposure baked at 110 °C. The coated wafers are then treated with 0.26N aqueous tetramethylammonium hydroxide solution to develop the imaged resist layer.

### Example 3

A positive-acting, chemically amplified photoresist composition was prepared by combining the following polymer (resin), where the monomer amounts indicated are mole 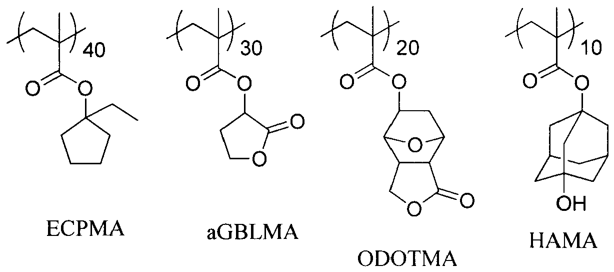 percentages, with a mixture of the following photoacid generators: triphenylsulfonium hexahydro-4,7-epoxyisobenzofuran-1(3H)-one, 6-(2,2'-difluoro-2-sulfonatoacetic acid ester (TPS-ODOT-DFMS) (6.523% of total solids); and t-butylphenyl tetramethylenesulfonium 4-adamantanecarboxyl-1,1,2,2-tetrafluorobutane sulfonate (TBPTMS-Ad-TFBS) (10.085% of total solids). An amount of a multi-amide quencher from the following Table 1 was also added to the composition. The amount of quencher used was selected to target an exposure dose of 25 mJ/cm². The photoresist was formulated in a solvent blend of propylene glycol methyl ether acetate / methyl-2-hydroxy-iso-butyrate / cyclohexanone (30/55/15 wt%). The total solids content of the photoresist formulation was 3-4%.

**Table 1**

| Sample | Multi-amide Quencher |
|---|---|
| 3-1 | N,N'-diacetylethylenediamine |
| 3-2 | N,N,N',N'-tetramethyltartardiamide |
| 3-3 | Piperazine-1,4-dicarbaldehyde |
| 3-4 | *trans*-N,N'-(cyclohexane-1,2-diyl)diacetamide |
| 3-5 | N,N,N',N'-tetramethylmalonamide |
| 3-6 | N,N,N',N',-tetrabutylmalonamide |

### Example 4

A comparative photoresist formulation ("Comparative") was prepared by repeating Example 3, except that the quencher was N-allylcaprolactam, a conventional quencher compound. N-allylcaprolactam is a mono-amide compound.

### Example 5

300 mm silicon wafers were spin-coated with ART™26N antireflectant (Rohm and Haas Electronic Materials) to form a first bottom antireflective coating (BARC) on a TEL CLEAN TRACK™ LITHIUS™ i+ coater/developer. The wafers were baked for 60 seconds at 205 °C, yielding a first BARC film thickness of 77 nm. A second BARC layer was next coated over the first BARC using AR™124 antireflectant (Rohm and Haas Electronic Materials), and was baked at 205 °C for 60 seconds to generate a 23 nm top BARC layer. Photoresist formulations of either Example 3 or 4 were then coated on the dual BARC-coated wafers and soft-baked at 110 °C for 60 seconds on a TEL CLEAN TRACK™ LITHIUS™ i+ coater/developer to provide a resist layer thickness of 110 nm. Next, a 30 nm immersion top antireflective layer was spin coated over the photoresist layer using OC2000 (Rohm and Haas Electronic Materials).

The photoresist-coated wafers were exposed through a mask having 45 nm lines and 90 nm pitch on an ASML TWINSCAN™ XT:1900i immersion scanner using a dipole illumination with 1.30 NA, 0.97 outer sigma, 0.77 inner sigma and X polarization. The exposed wafers were post-exposure baked at 95 °C for 60 seconds and then developed using 0.26N tetramethammonium hydroxide.

The lithographic results are reported in Table 2.

**Table 2**

| Sample | Es (mJ/cm²) | %EL | MEEF | LWR (nm, 3σ) |
|---|---|---|---|---|
| 3-1 | 24.4 | 18.2 | 1.23 | 4.0 |
| 3-2 | 33.7 | 18.0 | 1.47 | 3.6 |
| 3-3 | 22.9 | 14.4 | - | - |
| 3-4 | 27.9 | 29.0 | 0.93 | 2.7 |
| 3-5 | 26.4 | 16.2 | 1.42 | 4.1 |
| 3-6 | 27.7 | 27.4 | 1.00 | 2.8 |
| Comparative | 22.3 | 12.9 | 2.35 | 5.4 |

Es (Energy to size) is the exposure dose in mJ/cm² of 193 nm wavelength radiation required to image a specified feature (45 nm line/space pattern with 90 nm pitch) while at best focus (+0.01 µm).

EL (Exposure Latitude) is the sensitivity of line width to the exposure dose. A larger %EL is desired.

MEEF (Mask Error Enhancement Factor) is the change in a feature's line width as printed on the wafer compared to the change in line width on the mask (normalized by magnification). For instance, a MEEF of 2.0 would give a 2nm change on the wafer for every 1nm change on the mask (normalized by magnification). A MEEF value of 1 or lower is preferred. For the examples given, MEEF is calculated as follows.

Exposure arrays are imaged where the Es is near the center of the array. The dose increment is ~3% of Es. Exposure latitude plots are generated for 43 nm, 44 nm, 45 nm, 46 nm and 47 nm lines all with 90 nm pitch. Second order polynomial fits are then made for each of the five plots over a range of 0.8x CD to 1.2x CD, where CD is the target line width. The sizing dose, Es, is calculated for the 45 nm line feature. At this Es value, the line width is calculated for the 43 nm, 44 nm, 46 nm and 47 nm lines using the second order polynomial fit. The calculated line width values are then plotted against the mask line widths of 43 nm, 44 nm, 45 nm, 46 nm and 47 nm. A linear fit is then made to the 5 points, the slope of which is the MEEF.

LWR (Line Width Roughness) is generally defined as 3σ of the line width over a range of spatial frequencies. The lower the LWR value, the smoother the line.

As can be seen from the above data, the multi-amide compound quenchers of the invention provide improved lithographic performance (Es, %EL, MEEF and LWR) as compared to conventional mono-amide compound quenchers.

## Claims

1. A photoresist composition comprising:
(a) one or more resins;
(b) one or more photoacid generator compounds; and
(c) one or more multi-amide compounds.

2. The photoresist composition of claim 1 wherein the one or more multi-amide compounds are non-polymeric.

3. The photoresist composition of claim 1 wherein the one or more multi-amide compounds are polymeric.

4. The photoresist composition of claim 1 wherein the one or more multi-amide compounds each have a molecular weight of less than 2000.

5. The photoresist composition of claim 1 wherein the one or more multi-amide compounds contain one or more of the following moieties: hydroxyl, carboxyl, carboxy(C₁-C₃₀)alkyl, (C₁-C₃₀)alkoxy, sulfonyl, sulfonic acid, sulfonate ester, cyano, halo, and keto.

6. The photoresist composition of claim 1 wherein the one or more multi-amide compounds contain from 2 to 6 amide groups.

7. The photoresist composition of claim 1 wherein at least one of the one or more multi-amide compounds has the formula: 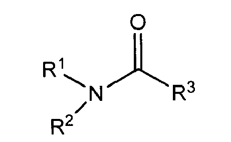 wherein R¹, R², and R³ are independently chosen from H, (C₁-C₃₀)alkyl, and amido-substituted(C₁-C₃₀)alkyl; R¹ and R², or R¹ and R³ may be taken together along with the atoms to which they are attached to form a 5- to 12-membered heterocyclic ring; and wherein at least one of R¹, R², and R³ is amido-substituted(C₁-C₃₀)alkyl.

8. The photoresist composition of claim 1 wherein the one or more multi-amide compounds are selected from: *cis*-N,N'-(cyclohexane-1,2-diyl)diacetamide; *trans*-N,N'-(cyclohexane-1,2-diyl)diacetamide; *cis*-N,N'-(cyclohexane-1,3-diyl)diacetamide; *trans*-N,N'-(cyclohexane-1,3-diyl)diacetamide; *cis*-N,N'-(cyclohexane-1,4-diyl)diacetamide; *trans*-N,N'-(cyclohexane-1,4-diyl)diacetamide; *cis*-N,N'-(cyclohexane-1,2-diyl)bis(N-methylacetamide); *trans*-N,N'-(cyclohexane-1,2-diyl)bis(N-methylacetamide); N,N'-diacetylethylenediamine; N,N,N',N'-tetramethyltartardiamide; piperazine-1,4-dicarbaldehyde; N,N,N',N'-tetramethylmalonamide; N,N,N',N',-tetrabutylmalonamide; N,N,N',N'-tetrakis(2-hydroxyethyl)adipamide; and (adipoylbis(azanetriyl))tetrakis(ethane-2,1-diyl) tetra-tert-butyl tetracarbonate.

9. A method for forming a photoresist relief image comprising:
(a) applying a coating layer of a photoresist composition of claim 1 on a substrate;
(b) exposing the photoresist coating layer to patterned activating radiation and developing the exposed photoresist layer to provide a relief image.

10. The method of claim 9 wherein the photoresist coating layer is immersion exposed.
